# EUROPÄISCHE PATENTSCHRIFT

(11) **EP 1 364 319 B1**
(45) Veröffentlichungstag und Bekanntmachung des Hinweises auf die Patenterteilung: **09.07.2008**
(21) Anmeldenummer: 02706714.9
(22) Anmeldetag: 17.01.2002
(51) Int. Cl.: G06F 17/50

(54) **VERFAHREN ZUR SEPARIERUNG REDUNDANTER SYSTEME WÄHREND DES DESIGNS VON KUNDENSPEZIFISCHEN SCHALTKREISEN**
METHOD FOR ISOLATING REDUNDANT SYSTEMS WHEN DESIGNING CLIENT-SPECIFIC PRINTED BOARDS
PROCEDE PERMETTANT DE SEPARER DES SYSTEMES REDONDANTS LORS DE LA CONCEPTION DE CIRCUITS DE COMMUTATION SPECIFIQUES AUX BESOINS DU CLIENT

(30) Priorität: 19.01.2001 DE 10102499; 10.10.2001 DE 10149930
(43) Veröffentlichungstag der Anmeldung: 26.11.2003
(73) Patentinhaber: Continental Teves AG & Co. oHG, 60488 Frankfurt am Main (DE)
(72) Erfinder: KIRSCHBAUM, Andreas, 64347 Griesheim (DE)
(86) Internationale Anmeldenummer: PCT/EP2002/000416
(87) Internationale Veröffentlichungsnummer: WO 2002/057963

(56) Entgegenhaltungen:
- WO-A-98/53374
- SMITH S E: "TRIPLE REDUNDANT FAULT TOLERANCE: A HARDWARE-IMPLEMENTED APPROACH" ISA TRANSACTIONS, INSTRUMENT SOCIETY OF AMERICA. PITTSBURGH, US, Bd. 30, Nr. 4, 1991, Seiten 87-95, XP000275596 ISSN: 0019-0578
- "Automation Software Information Technology" TÜV RHEINLAND, [Online] 20. April 1999 (1999-04-20), XP002236214 Gefunden im Internet: <URL:http://tuvasi.com/asic_03.htm> [gefunden am 2003-03-26]
- BANNATYNE R: "Dependable auto systems emerge" EE TIMES, [Online] 8. September 2000 (2000-09-08), XP002236213 Gefunden im Internet: <URL:http://www.eetimes.com/story/OEG20000 728S0023> [gefunden am 2003-03-26]
- KIRKPATRICK D A ET AL: "Techniques For Crosstalk Avoidance In The Physical Design Of High-performance Digital Systems" IEEE/ACM INTERNATIONAL CONFERENCE ON COMPUTER-AIDED DESIGN. DIGEST OF TECHNICAL PAPERS (ICCAD). SAN JOSE, NOV. 6 - 10, 1994, LOS ALAMITOS, IEEE COMP. SOC. PRESS, US, 6. November 1994 (1994-11-06), Seiten 616-619, XP010252184 ISBN: 0-8186-6417-7

## Beschreibung

Die Erfindung betrifft ein Verfahren gemäß Oberbegriff von Anspruch 1.

Es sind bereits verschiedene Verfahren zum Design von kundenspezifischen integrierten Schaltkreisen (ASICS, FGPAs) im Bereich der Mikroelektronik bekannt. Ein ASIC (Application Specific Integrated Circuit) ist eine kunden- bzw. anwendungsspezifisch entwickelte integrierte Schaltung (IC, "Chip"). ASICs werden eingesetzt, wenn ein Optimum bezüglich Baugröße, Leistungsfähigkeit und geringer elektrischer Verlustleistung gefordert ist. Je nach ASIC-Technologie wird bereits ab relativ geringen Stückzahlen auch ein Kostenvorteil erzielt. Das Spektrum reicht dabei von einfachen, programmierbaren Bauelementen (PLDs) über komplexere frei programmierbare Gate-Arrays (FPGAs) bis hin zu Full-Custom ASICs mit Analog- und Digitalteil. Mit einer an sich bekannten geeigneten Entwicklungssoftware, wie OCEAN der Delft U-niversity (NL), Synopsis oder CADENCE, können Maskensätze (Layout) für spezifische Schaltungsherstellungsprozesse (z.B. CMOS, BiCMOS) bestimmter Firmen vom Kunden durch Zusammensetzen von komplexen, in Bibliotheken abrufbaren Bausteinen (IP), hergestellt werden. Die Entwicklungswerkzeuge erlauben somit ein Design von Mikroschaltkreisen innerhalb von herstellerseitig vorgegebenen Grenzen. Die Entwicklung der Schaltungen erfolgt dabei mit Hardware-Beschreibungssprachen, wie VHDL, Verilog oder mittels SDL für signalflußorientierte Anwendungen.

Die Veröffentlichung "Triple Redundant Fault Tolerance: A Hardware Implemented Approach", Smith, S. E., ISA Transactions, Instrument Society Of America, Pittsburgh, US, Bd. 30, Nr. 4, 1991, Seiten 87-95, ISSN: 0019-0578 beschreibt einen redundanten, fehlertoleranten Mikrocomputer mit drei Prozessormodulen, welche in Kartentechnik zu einem Gesamtrechensystem verbunden sind. Der darin eingesetzte Controller basiert auf einer HIFT-Architektur, welche kundenspezifische ASICS einsetzt.

Unter anderem aus dem Artikel "Dependable Auto Systems Emerge", Bannatyne, R., EE Times, [Online] 8. September 2000 (2000-09-08), geht ein elektronisches Steuergerät zur Regelung der Bremsen von Kraftfahrzeugen, z.B. in elektronischen Fahrdynamikregelungen (ESP) oder Blockierverhinderungsregelungen (ABS) hervor, bei dem die Regelung und Steuerung unterschiedlichster Funktionen durch Mikroprozessorsysteme vorgenommen wird. Aufgrund der hohen geforderten Zuverlässigkeit an entsprechende Steuergeräte werden die sicherheitskritischen elektronischen Schaltkreise ganz oder teilweise redundant ausgeführt.

Ein grundlegendes Prinzip der Redundanz ist, daß die mehrfach vorhandenen Teilsysteme (z.B. zwei gleichartige Mikroprozessoren) unabhängig voneinander arbeiten und sich gegenseitig überwachen bzw. korrigieren können. Es ist aber auch möglich, daß die ordnungsgemäße Funktion dieser mehrfach vorhandenen Teilsysteme von einer dritten Schaltungseinheit verglichen wird und bei Abweichung der Funktion weitere geeignete Schritte vorgenommen werden.

Werden nun entsprechende Schaltkreise mit Redundanz mit an sich bekannten Entwicklungswerkzeugen, wie zum Beispiel CADENCE, entwickelt, so sind die mehrfach ausgeführten Teilsysteme in der Regel mehr oder weniger miteinander verflochten.

In dem Dokument "Automation Software Information Technology" TÜV Rheinland, [Online] 20. April 1999 (1999-04-20), wird ein Herstellungsverfahren für einen fehleroptimierten anwenderspezifischen Chip (ASIC) beschrieben, bei dem eine Separierung zwischen Leiterbahnen und funktionellen Blöcken, die nicht zusammengehören, vorgenommen wird. Hierdurch kann ein Optimierung hinsichtlich Übersprechen und dem Auftreten von Kurzschlüssen erreicht werden.

Es hat sich gezeigt, daß die mit Hilfe der zuvor beschriebenen Entwicklungswerkzeuge hergestellten Schaltungsanordnungen bezüglich der Betriebssicherheit die gestellten Anforderungen noch nicht vollständig erfüllen.

Die Erfindung schlägt daher ein Verfahren gemäß Anspruch 1 vor, mit dem die Betriebssicherheit der hergestellten Schaltungsanordnungen weiter erhöht werden kann.

Nach dem Verfahren der Erfindung erfolgt eine Herstellung von integrierten Schaltungsanordnungen für Kraftfahrzeugregelungssysteme durch Erstellung eines Layouts mittels eines automatisierten Verfahrens, wobei dieses Verfahren bevorzugt entweder automatisch in einem Computersystem oder teilweise automatisch, in dem für vorgesehene Personen (z.B. Entwicklungsingenieure) in Interaktion mit einem Computersystem treten, durchgeführt wird.

Für Schaltungsanordnungen, welche bevorzugt mehrere integrierte teil- oder voll-redundante Teilsysteme enthalten, ist es für eine möglichst sichere Funktion sinnvoll, neben der logischen Separierung auch eine physikalische Separierung der Teilsysteme während des Layout-Designs vorzunehmen.

Die getrennten Teilsysteme sind vorzugsweise redundante Schaltkreise (5,6) eines elektronischen Steuergeräts für Kraftfahrzeuge, insbesondere eines elektronischen Steuergeräts für Kraftfahrzeugbremssysteme.

Vorzugsweise befinden sich alle Teilsysteme der hergestellten Schaltungsanordnung auf einem gemeinsamen Chip.

Nach der Erfindung werden die Teilsysteme physikalisch voneinander getrennt. Es hat sich gezeigt, daß bei einer nicht ausreichenden physikalischen Trennung der Teilsysteme Kreuzkopplungen der Teilsysteme auftreten können, deren Fehleranalyse äußerst zeitaufwendig oder gar unmöglich ist.

Die Herstellung der Schaltungsanordnungen erfolgt bevorzugt mittels Entwicklungswerkzeugen, welche für die Erstellung von Verdrahtungsnetzwerken geeignet sind, wie insbesondere CADENCE. Mit entsprechenden Entwicklungswerkzeugen, welche auf aktuellen Rechnersystemen in Form eines Computerprogramms ablaufen, lassen sich vorgefertigte Halbleiterchips (Semi-Custom Design) gemäß den gestellten Anforderungen fertigstellen.

Bei den vorgefertigten Halbleiterchips handelt es sich bevorzugt um solche, die in Sea-Of-Gates Technologie hergestellt wurden.

Die vollständige physikalische Trennung von Teilsystemen wird in der Sea-Of-Gates-Technologie mit den derzeit verfügbaren Maskenherstellungswerkzeugen zur Herstellung von Leiterbahnenstrukturen nicht in ausreichendem Maße unterstützt. So führt zum Beispiel der automatisierte Vorgang des "Entwirrens" der Netzwerke (Routing) mit einem Autorouter häufig zu den bereits weiter oben erwähnten unerwünschten Kreuzkopplungen. Die Folge ist ein aufwendiger manueller Überprüfungsprozeß (Reviewpozeß), bei dem das fertige Layout nachbearbeitet werden muß, um die logische und physikalische Separierung zu erreichen.

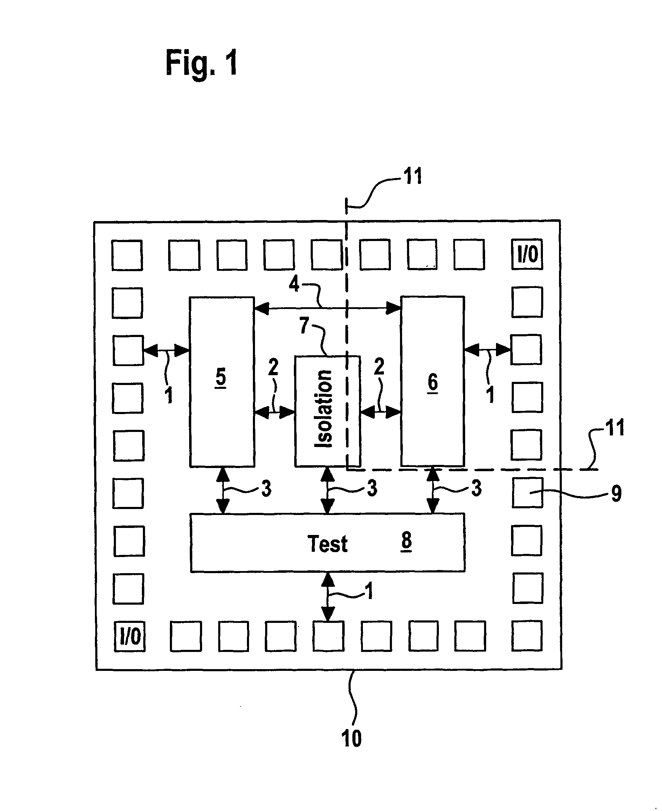

Es zeigt
- Fig. 1: ein Beispiel eines nach dem Verfahren der Erfindung herstellbaren Hardwaresystems, welches in elektronischen Bremssystemen einsetzbar ist.

Fig. 1 zeigt ein Layout auf Mikrochip 10 für einen Mikrocontroller, welches zweifach redundant aufgebaut ist. Auf Chip 10 sind zwei redundante Teilsysteme 5 und 6 vorgesehen, die im wesentlichen intern gleich aufgebaut sind. Beide Teilsysteme sind durch das Isolationsmodul 7 getrennt, über das zulässige Verbindungen 2 der Teilsysteme (z.B. Taktversorgung, Reset, Vergleichsergebnisse etc.) geführt werden. Aus Komplexitätsgründen wird in der Regel die ebenfalls auf dem Chip angeordnete Testlogik 8 zum Überwachen des fehlerfreien Betriebs nicht redundant ausgelegt. Die Teilsysteme 5 und 6, sowie die Testlogik 8 sind mit Kontaktflächen 9 für die elektrischen Zuleitungen des Chips durch Verbindungen 1 verbunden.

Gemäß dem Verfahren nach der Erfindung wird zum Zwecke der physikalischen Separierung der Teilsysteme 5 und 6 eine Validierung, wie nachfolgend beschrieben, durchgeführt.

Zunächst wird eine logische Separierung in der Register-Übertragungs-Ebene (RTL-Ebene) vorgenommen. Jede Instanz der Hardware-Beschreibungssprache (HDL-Entity) wird während des Entwurfs der Register-Übertragungs-Ebene einem Teilsystem einer bestimmten Systemklasse zugeordnet.

Im vorliegenden Beispiel sind dies die Klassen:
A) Teilsystem 5,
B) Teilsystem 6,
C) Isolationsmodul 7 und
D) Testmodul 8.

Anschließend werden alle Bussysteme auf der höchsten Design-Ebene (RTL Top-Level) logisch durch mehrfache Punkt-zu-Punkt Verbindungen ersetzt. Dann werden, basierend auf der vorstehend erstellten Beschreibung, über ein Skript (z.B. mit dem Synthesewerkzeug) automatisch alle Verbindungen zwischen den Klassen A) bis D) extrahiert und wie folgt klassifiziert:
- Klasse 1:: Verbindungen 1 zu den Kontaktflächen 9,
- Klasse 2:: Verbindungen 2 von den Teilmodulen 5,6 zum Isolationsmodul 7,
- Klasse 3:: Verbindungen 3 zum Testmodul 8 und
- Klasse 4:: Verbindungen 4 zwischen den Teilmodulen 5,6.

Durch die nach der vorstehend beschriebenen Methode durchgeführte Klassifizierung der Module und Verbindungen wird somit eine automatisierte Möglichkeit zur Überprüfung der physikalischen Trennung auf Layoutebene geschaffen.

Wenn der besagte Klassifizierungsvorgang bewerkstelligt ist, werden die Ergebnisse nach den folgenden Regeln automatisch (per Skript) ausgewertet:
- Regel 1:: Die Klassen 1-3 stellen zulässige Verbindungen dar und sind zu ignorieren.
- Regel 2:: Ist Klasse 4 nicht leer, so handelt es sich um einen Fehler in der logischen Separierung der Teilsysteme. Das eingangs festgelegte Design muß dann geändert werden. Die vorstehenden Schritte werden im Anschluß daran neu durchlaufen.

Wenn das vorstehend beschriebene Teil des Verfahrens abgeschlossen ist, wird das Design der Layout-Ebene (Physikalische Separierung) durchgeführt.

Die vorstehend beschriebenen einzelnen Klassen werden zunächst per Skript automatisch farblich hervorgehoben und die Plazierung der zugehörigen Zellen optisch mit dem Layoutwerkzeug überprüft.

Nun wird im Layout eine gedachte physikalische Separationslinie 11 festgelegt, welche durch das Isolationsmodul 7 verläuft und die beiden Teilsystem in der Weise voneinander trennt, daß das Testmodul 8 auf der abgetrennten Seite von nur einem der Teilsysteme liegt. Dann werden alle Leitungen, die im Layout Separationslinie 11 kreuzen über das Layoutwerkzeug erfaßt. Die erfaßten Leitungen werden danach mit den bereits auf RTL-Ebene gefundenen Verbindungen automatisch verglichen. Werden nun zusätzliche Verbindungen gefunden, so liegt ein Fehler in der physikalischen Separierung vor. Das Layout muß dann modifiziert werden.

Mit Hilfe des beschriebenen Verfahrens ist eine beschleunigte Entwicklung von integrierten elektronischen Schaltungen mit mehrfach ausgeführten Teilsystemen möglich, da auftretende Fehler bereits in einer frühen Designphase korrigiert werden können. Demgegenüber wird bei bekannten Verfahren die Überprüfung der logischen Separierung der Teilsysteme erst am Ende des Entwurfsablaufs nach Fertigstellung des Layouts manuell und optisch durchgeführt. Werden hierbei, was häufig vorkommt, Fehler gefunden, ist ein erheblich zeit- und kostenintensives neu zu durchlaufendes Design notwendig.

## Patentansprüche

1. Verfahren zur Herstellung von integrierten Schaltungsanordnungen für Kraftfahrzeugregelungssysteme durch Erstellung eines Layouts mittels eines automatisierten Verfahrens, **dadurch gekennzeichnet, daß** mindestens zwei logisch getrennte Teilsysteme (5,6) vorgesehen sind und neben der logischen Trennung zusätzlich eine räumliche (physikalische) Trennung der Teilsysteme auf der zur Verfügung stehenden Fläche der Schaltungsanordnung vorgenommen wird und außerdem
ein Isolationsmodul (7) vorgesehen wird, welches mit den vorhandenen Teilsystemen über Bussysteme (2) verbunden ist und wobei durch das Isolationsmodul eine zur Entwirrung der Bussysteme (1,2,3) vorgesehene Separationslinie (11) gelegt wird.

2. Verfahren nach Anspruch 1, **dadurch gekennzeichnet, daß** die getrennten Teilsysteme redundante Schaltkreise (5,6) eines elektronischen Steuergeräts für Kraftfahrzeuge sind.

3. Verfahren nach Anspruch 1 oder 2, **dadurch gekennzeichnet, daß** die durch das automatisierte Verfahren vorgenommene Trennung in zwei räumlich getrennte Teilbereiche nachträglich noch einmal überprüft wird.

4. Verfahren nach einem der Ansprüche 1 bis 3, **dadurch gekennzeichnet, daß** die integrierte Schaltungsanordnung
ein anwenderspezifischer Schaltkreis, welcher insbesondere in Sea-Of-Gates-Technologie hergestellt wurde, ist.

5. Verfahren nach einem der Ansprüche 1 bis 4, **dadurch gekennzeichnet, daß** die logische Trennung in der Register-Übertragungs-Ebene erfolgt, wobei jeder Instanz der Hardware-Beschreibungs-Sprache ein Teilsystem einer bestimmten Klasse zugeordnet wird.

6. Verfahren nach Anspruch 5, **dadurch gekennzeichnet, daß** nach der logischen Trennung alle Bussysteme auf der höchsten Design-Ebene logisch durch mehrfache Punkt-zu-Punkt Verbindungen ersetzt werden.

7. Verfahren nach Anspruch 6, **dadurch gekennzeichnet, daß** die erstellten Punkt-zu-Punkt Verbindungen in Klassen eingeteilt werden.

8. Verfahren nach einem der Ansprüche 1 bis 7, **dadurch gekennzeichnet, daß** neben den Teilsystemen eine gemeinsame Testlogik (8) vorgesehen ist, welche mit den vorhandenen Teilsystemen über ein Bussystem (3) verbunden ist.

## Claims

1. Method for producing integrated circuit arrangements for automotive vehicle control systems by establishing a layout using an automated process,
**characterized in that** at least two logically isolated subsystems (5, 6) are provided and, in addition to the logical isolation, a spatial (physical) isolation of the subsystems is effected on the surface available on the circuit arrangement, and furthermore an isolation module (7) is provided which is connected to the existing subsystems by way of bus systems (2), and a separation line (11) intended for disentangling the bus systems (1, 2, 3) is passed through the isolation module.

2. Method as claimed in claim 1,
**characterized in that** the isolated subsystems are redundant circuits (5, 6) of an electronic control device for automotive vehicles.

3. Method as claimed in claim 1 or 2,
**characterized in that** the isolation into two spatially isolated partial areas effected by the automated process is once more examined retroactively.

4. Method as claimed in any one of claims 1 to 3,
**characterized in that** the integrated circuit arrangement is a client-specific circuit which was produced especially in Sea-Of-Gates technology.

5. Method as claimed in any one of claims 1 to 4,
**characterized in that** the logical isolation is effected in the register transmission level, with one subsystem of a defined class being associated with each entity of the hardware descriptive language.

6. Method as claimed in claim 5,
**characterized in that** after the logical isolation, all bus systems on the highest design level are replaced logically by multiple point-to-point connections.

7. Method as claimed in claim 6,
**characterized in that** the established point-to-point connections are subdivided into classes.

8. Method as claimed in any one of claims 1 to 7,
**characterized in that** beside the subsystems, a common test logic (8) is provided which is connected to the existing subsystems by way of a bus system (3).

## Revendications

1. Procédé de fabrication d'agencements de circuits intégrés pour systèmes de régulation de véhicule par réalisation d'une topologie au moyen d'un procédé automatisé, **caractérisé en ce que** sont prévus au moins deux systèmes partiels (5, 6) séparés logiquement et, outre la séparation logique, il est procédé en supplément à une séparation spatiale (physique) des systèmes partiels sur la surface disponible de l'agencement de circuits, et il est prévu en outre un module d'isolation (7) qui est relié aux systèmes partiels existants par des systèmes de bus (2), et une ligne de séparation (11), prévue pour séparer les systèmes de bus (1, 2, 3), étant créée par le module d'isolation.

2. Procédé selon la revendication 1, **caractérisé en ce que** les systèmes partiels séparés sont des circuits de commutation (5, 6) redondants d'un appareil de commande électronique pour véhicule automobile.

3. Procédé selon la revendication 1 ou 2, **caractérisé en ce que** la séparation, opérée par le procédé automatisé, est vérifiée encore une fois ultérieurement dans deux zones partielles séparées dans l'espace.

4. Procédé selon l'une quelconque des revendications 1 à 3, **caractérisé en ce que** l'agencement de circuits intégrés est un circuit de commutation spécifique de l'application qui a été réalisé en particulier dans une technologie "mer de portes".

5. Procédé selon l'une quelconque des revendications 1 à 4, **caractérisé en ce que** la séparation logique s'effectue dans le plan de transmission de registre, à chaque instance du langage descriptif du matériel étant associé un système partiel d'une classe déterminée.

6. Procédé selon la revendication 5, **caractérisé en ce qu'**après la séparation logique, tous les systèmes de bus sont remplacés logiquement, sur le plan de design le plus élevé, par plusieurs liaisons point à point.

7. Procédé selon la revendication 6, **caractérisé en ce que** les liaisons point à point réalisées sont partagées en classes.

8. Procédé selon l'une quelconque des revendications 1 à 7, **caractérisé en ce qu'**il est prévu, outre les systèmes partiels, une logique test (8) commune qui est reliée aux systèmes partiels existants par un système de bus (3).
